(19) **Europäisches Patentamt / European Patent Office / Office européen des brevets**

(11) **EP 2 661 815 B1**

(12) **FASCICULE DE BREVET EUROPEEN**

(45) Date de publication et mention de la délivrance du brevet:
**14.11.2018 Bulletin 2018/46**

(21) Numéro de dépôt: **12700017.2**

(22) Date de dépôt: **03.01.2012**

(51) Int Cl.:
**H03M 13/39** (2006.01)     **H03M 13/41** (2006.01)

(86) Numéro de dépôt international:
**PCT/EP2012/050047**

(87) Numéro de publication internationale:
**WO 2012/093116 (12.07.2012 Gazette 2012/28)**

(54) **PROCÉDÉ DE CORRECTION DE MESSAGES CONTENANT DES BITS DE BOURRAGE**

VERFAHREN ZUR KORREKTUR VON NACHRICHTEN MIT BITSTOPFUNG

METHOD FOR CORRECTING MESSAGES CONTAINING BIT STUFFING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **03.01.2011 FR 1150019**

(43) Date de publication de la demande:
**13.11.2013 Bulletin 2013/46**

(73) Titulaire: **Centre National d'Etudes Spatiales 75039 Paris Cedex 01 (FR)**

(72) Inventeurs:
- **PREVOST, Raoul**
  **F-11200 Saint-André-de-Roquelongue (FR)**
- **BONACCI, David**
  **F-31500 Toulouse (FR)**
- **COULON, Martial**
  **F-31500 Toulouse (FR)**
- **TOURNERET, Jean-Yves**
  **F-31500 Toulouse (FR)**
- **LE MAITRE, Julia**
  **F-31190 Grepiac (FR)**
- **MILLERIOUX, Jean-Pierre**
  **F-31400 Toulouse (FR)**

(74) Mandataire: **Gaillarde, Frédéric F. Ch. et al Cabinet Germain & Maureau 31-33, rue de la Baume 75008 Paris (FR)**

- **JUAN SONG ET AL: "Design and implementation of WTB controller using SOPC technology", SIGNAL PROCESSING, 2008. ICSP 2008. 9TH INTERNATIONAL CONFERENCE ON, IEEE, PISCATAWAY, NJ, USA, 26 octobre 2008 (2008-10-26), pages 2804-2807, XP031369651, DOI: DOI:10.1109/ICOSP.2008.4697730 ISBN: 978-1-4244-2178-7**
- **Robin Hoel: "Design note DN504, Fec Implementation", Texas Instruments Design Notes Repository , 1 janvier 2007 (2007-01-01), pages 1-11, XP002647992, Extrait de l'Internet: URL:http://focus.ti.com/lit/an/swra113a/swra113a.pdf [extrait le 2011-07-06]**
- **Anonym: "Convolutional code", Wikipedia , 29 avril 2010 (2010-04-29), XP002671325, Extrait de l'Internet: URL:http://web.archive.org/web/20100429174641/http://en.wikipedia.org/wiki/Convolutional_code [extrait le 2012-03-13]**
- **PETROVIC D ET AL: "List Viterbi decoding with continuous error detection for magnetic recording", GLOBECOM'01. 2001 IEEE GLOBAL TELECOMMUNICATIONS CONFERENCE. SAN ANTONIO, TX, NOV. 25 - 29, 2001; [IEEE GLOBAL TELECOMMUNICATIONS CONFERENCE], NEW YORK, NY : IEEE, US, vol. 5, 25 novembre 2001 (2001-11-25), pages 3007-3011, XP010747545, DOI: DOI:10.1109/GLOCOM.2001.965979 ISBN: 978-0-7803-7206-1**

(56) Documents cités:
**EP-A1- 1 928 179     EP-A2- 1 089 442**

• BOLLATI G ET AL: "A 450 Mbit/s parallel read/write channel with parity check and 16-state time variant Viterbi", PROCEEDINGS OF THE IEEE 2000 CUSTOM INTEGRATED CIRCUITS CONFERENCE. (CICC 2000). ORLANDO, FL, MAY 21-24, 2000; [IEEE CUSTOM INTEGRATED CIRCUITS CONFERENCE.CICC], vol. CONF. 22, 24 mai 2000 (2000-05-24), pages 319-322, XP002288505, ISBN: 978-0-7803-5810-2

**Description**

**Domaine technique**

La présente invention concerne un procédé de correction de messages contenant des bits (éléments binaires) de bourrage.

**Etat de la technique**

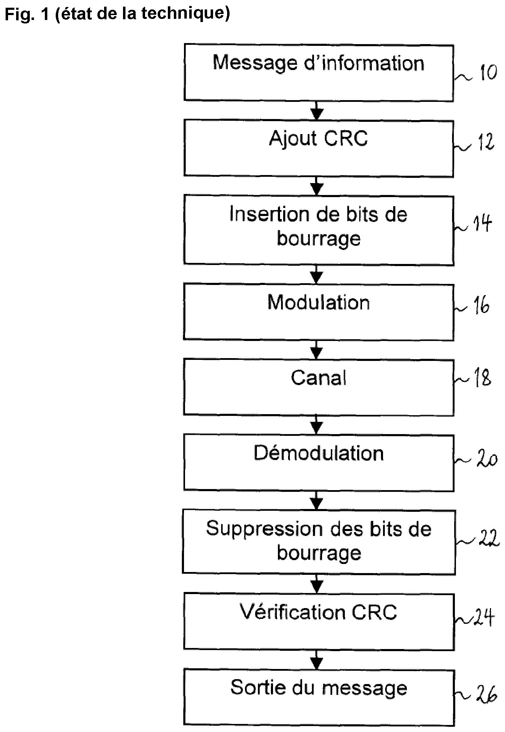

Une chaîne conventionnelle de transmission est illustrée à la figure 1. Dans une première étape 12, le message à transmettre 10 (message initial) est utilisé pour calculer un bloc de contrôle de redondance cyclique (CRC). La technique de CRC est communément appliquée pour détecter des erreurs de transmission par ajout de redondance. Le bloc de redondance est rattaché au message initial (par concaténation des séquences binaires du message et du bloc de redondance). Pour distinguer le message obtenu par rajout du bloc de redondance ou par une autre transformation préliminaire du message initial, on l'appellera dans la suite « message transformé ». Dans le contexte de ce document, le message initial peut être un message d'information ou tout autre message pouvant être représenté sous forme binaire.

Le bloc de CRC est une séquence binaire de longueur déterminée qui est obtenue par un hachage effectué sur le message initial. Un bloc de CRC de longueur n calculé sur un message initial d'une longueur quelconque permet de détecter toute rafale (en anglais « burst ») d'erreurs d'une longueur qui ne dépasse pas n et une fraction de $1 - 2^{-n}$ des rafales d'erreurs de longueur plus importante. On calcule le bloc de CRC par division polynomiale modulo 2. A cette fin, on associe au message initial un polynôme de message, ci-après noté $M(x)$. Le bloc de CRC correspond au reste $R(x)$ de la division polynomiale modulo 2 de $M(x) \cdot x^{n+1}$ par le polynôme générateur de degré $n + 1$, noté $G(x)$. Le quotient de la division peut être ignoré. Le degré du reste $R(x)$ ne peut être supérieur au degré de $G(x)$ moins un, c.-à-d. à $n$. Le cas échéant, on rajoute des bits 0 au reste $R(x)$ pour avoir un bloc de CRC de longueur fixe. Pour le calcul du bloc de CRC, on peut notamment utiliser un registre à décalage à rétroaction linéaire (en anglais : « linear feedback shift register »). Le paquet de données formé par le message initial auquel on a rattaché son bloc de CRC est parfois appelé « mot de code ».

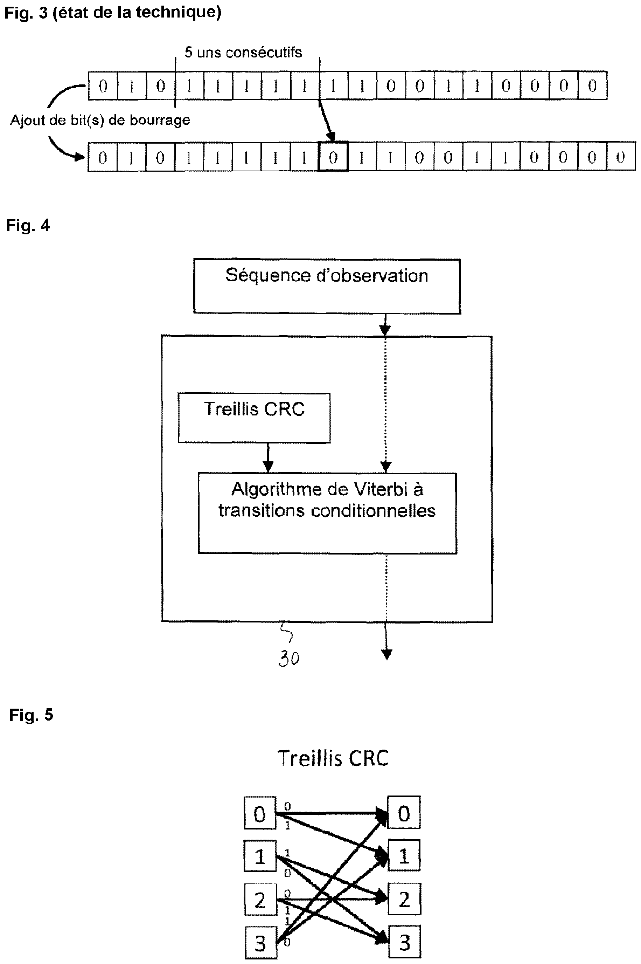

Lors de l'étape 14 suivante, les bits de bourrage (en anglais « stuffing bit » ou « stuffed bit »), qui ne représentent pas d'information ou de redondance, sont insérés dans le message transformé. Ces bits de bourrage sont typiquement utilisés pour limiter le nombre de bits consécutifs de la même valeur et introduire des transitions supplémentaires. Les transitions supplémentaires servent notamment à réduire des problèmes de synchronisation au niveau du récepteur ou pour éviter l'apparition de séquences binaires à signification spécifique (telles que des séquences de contrôle, par exemple). Le protocole HDLC (sigle anglais pour « High-Level Data Link Control », protocole de liaison de données de niveau 2) se sert de bits de bourrage pour éviter l'apparition du drapeau de fin de trame (qui correspond dans le cas de HDLC à la séquence binaire 01111110). Selon le protocole HDLC, un bit 0 est inséré derrière une séquence de cinq bits consécutifs de valeur 1, ce qui garantit que le drapeau de fin de trame n'apparaît pas au milieu d'un message. Ceci est illustré à la figure 3. Les bits de bourrage peuvent être de valeur 0 et/ou de valeur 1, selon les caractéristiques du protocole considéré. Dans les cas de HDLC ou d'AIS (sigle anglais pour « Automatic Identification System », système d'identification automatique), les bits de bourrage sont toujours des bits de valeur 0. Notons encore que le concept de l'insertion de bits de bourrage ne doit pas être confondu avec le concept de remplissage (en anglais « padding ») qui consiste en l'insertion de bits pour atteindre une longueur de séquence binaire prédéterminée.

On se sert ensuite du message transformé rembourré pour moduler (à l'étape de modulation 16) un signal aux fins de la transmission par le canal de transmission 18. L'étape de modulation 16 est éventuellement précédée d'un codage canal (qui n'est pas montré à la figure 1).

Du côté du récepteur, le signal transmis est démodulé (à l'étape de démodulation 20) et éventuellement décodé. Pour retrouver le message initial (les bits d'information), les bits de bourrage sont éliminés (étape 22). Pour détecter et/ou corriger des erreurs de transmission, le récepteur vérifie le CRC du message transmis à l'étape 24 avant de sortir le message vérifié/corrigé (étape 26) ou un message d'erreur au cas où la correction ne serait pas possible. Il y a différentes méthodes connues pour la vérification d'un CRC. Une de ces méthodes consiste à calculer le CRC sur la séquence de bits d'information reçue et à le comparer avec le CRC du message transmis. Une méthode pouvant être plus facilement implémentée en hardware utilise la propriété que le CRC d'une séquence binaire constituée d'un message suivi de son CRC est zéro, ce qui peut être exprimé comme :

$$CRC([\mathit{données}, CRC(\mathit{données})]) = 0$$

où $CRC(.)$ désigne le résultat du calcul de CRC et [.,.] la concaténation de deux séquences binaires. Selon cette méthode, on calcule donc le CRC du message transmis (c.-à-d. sur l'ensemble des bits d'information et des bits de redondance).

Si le résultat est 0, le message est considéré transmis correctement. Il existe aussi des méthodes permettant de détecter l'emplacement d'un bit erroné. Une telle méthode est notamment décrite dans l'article de B. McDaniel, « An algortithm for error correcting cyclic redundancy checks, » C/C++ Users Journal, p. 6, 2003. Des développements de cette méthode permettent de corriger plusieurs bits erronés (voir p.ex. S. Babaie, A. K. Zadeh, S. H. Es-hagi, N. J. Nvimipour, « Double bits error correction using CRC method, » International Conférence on Semantics, Knowledge and Grid, no 5, pp. 254-257, 2009 et C. Shi-yi and L. Yu-bai, « Error correcting cycle redundancy checks based on confidence declaration, » ITS Télécommunications Proceedings, no 6, pp. 511-514, 2006). Or, toutes ces méthodes présupposent que les bits de bourrage aient été éliminés du message reçu avant qu'elles puissent être appliquées, ce qui réduit fortement leur intérêt en pratique.

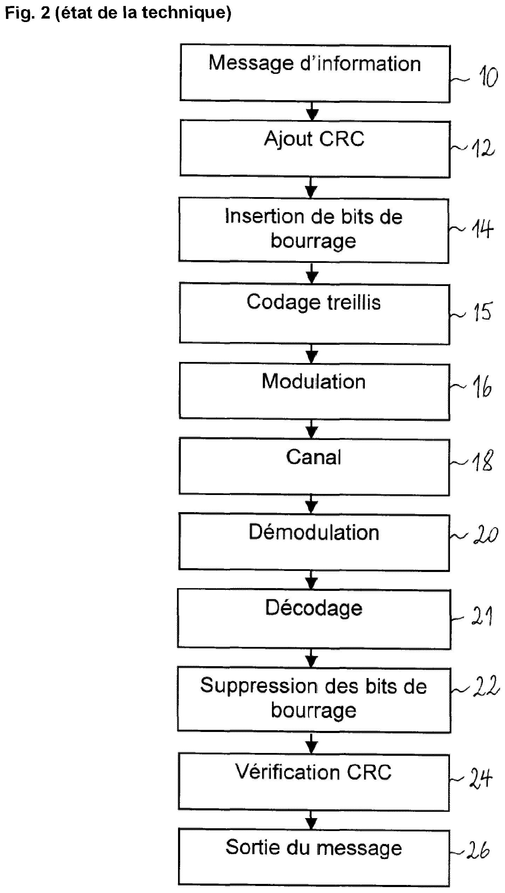

La figure 2 montre une chaîne conventionnelle de transmission qui se distingue de celle de la figure 1 par le fait que le message transformé est codé en treillis (en anglais « trellis coded ») à l'étape 15 après insertion de bits de bourrage. Du côté du récepteur, le signal transmis est démodulé (à l'étape de démodulation 20) et décodé (à l'étape de décodage 21), p.ex. à l'aide de l'algorithme de Viterbi. Les bits de bourrage sont supprimés après le décodage mais avant la vérification de CRC.

Une méthode de codage avec bits de bourrage et séquence de vérification de trame est présentée dans l'article «Design and implementation of WTB controller using SOPC technology». SIGNAL PROCESSING 2008. ICSP 2008. 9TH INTERNATIONAL CONFERENCE ON, IEEE, PISCATAWAY, NJ, USA, 26 octobre 2008, pages 2804-2807. Les bits de bourrage sont retirés avant la vérification de trame (FCS). Par ailleurs la technique FEC bien connue utilisant l'algorithme de Viterbi -sans bits de bourrage- est décrite dans «Design note DN504, FEC implementation », Texas Instruments Design Notes Repository, 1 janvier 2007, pages 1-11.

**Objet de l'invention**

Un objet de la présente invention est de proposer un procédé de correction de message qui est applicable en présence de bits de bourrage.

**Description générale de l'invention**

Le procédé selon l'invention s'applique à un message (message à corriger) dont la génération a impliqué une transformation d'un message initial et l'insertion de bits de bourrage dans le message transformé. La transformation peut notamment comprendre le calcul d'un bloc de CRC et le rattachement de ce bloc au message initial. Le procédé comprend la mise à disposition (p.ex. en sortie d'un démodulateur) d'une séquence d'observation contenant le message à corriger. Une pluralité d'hypothèses de chemin est alors construite à travers un treillis associé à la transformation au sens qu'il comprend des noeuds et des branches, où les noeuds représentent chacun un état d'une machine à états finis susceptible d'effectuer la transformation du message initial et où les branches représentent les transitions possibles entre les noeuds. Une transition entre un premier noeud représentant un premier état de la machine à états finis et un second noeud représentant un second état de la machine à états est possible si, en appliquant un bit de valeur 0 ou de valeur 1 en entrée de la machine à états finis lorsque celle-ci se trouve dans le premier état, elle passe au second état. Parmi les branches du treillis, certaines représentent des transitions conditionnelles empruntables uniquement en présence d'un bit de bourrage. Lors de la construction d'une hypothèse de chemin, des bits de bourrage sont détectés et les branches associées aux bits de bourrage détectés sont empruntées. Parmi les différentes hypothèses de chemin construites, on choisit celle qui se révèle la plus probable par rapport à la séquence d'observation.

Il convient de noter que la génération du message à corriger ne fait normalement pas partie du procédé selon l'invention (bien que cela ne soit pas exclu). Toutefois, le procédé ne s'applique qu'à des messages qui ont été générés d'une certaine façon. La forme sous laquelle doivent se présenter les messages à corriger, la transformation ainsi que les conditions qui gouvernent l'insertion de bits de bourrage sont normalement fixées dans un protocole. La correction d'un message ne peut se faire que si le message a été généré en conformité avec ce protocole.

La construction de la pluralité d'hypothèses de chemin à travers le treillis et la sélection sont basées, de préférence, sur l'algorithme de Viterbi ou sur l'algorithme SOVA (de l'anglais « Soft Output Viterbi Altgorithm », algorithme de Viterbi à sortie souple). D'éventuelles erreurs de transmission (jusqu'à un certain nombre d'erreurs) sont corrigées par la sélection de l'hypothèse de chemin la plus probable, c.-à-d. l'hypothèse de chemin présentant la distance minimale (de toutes les hypothèses construites) de la séquence d'observation.

Au cas où la transformation du message initial comprend le calcul d'un bloc de contrôle de redondance cyclique qui est assemblé au message initial pour produire le message transformé, les noeuds du treillis représentent chacun un état d'un calculateur (p.ex. un registre à décalage à rétroaction linéaire) susceptible d'avoir effectué le calcul du bloc de contrôle de redondance cyclique.

Lors de l'exécution du procédé, au fur et à mesure qu'une hypothèse de chemin est construite, un bit de bourrage est considéré détecté de préférence si les conditions selon lesquelles l'insertion d'un bit de bourrage est effectuée sont remplies. Si, par exemple, un bit de bourrage a été inséré immédiatement derrière chaque séquence de cinq bits consécutifs de valeur 1 avant la transmission du message, dans chaque hypothèse de chemin un bit qui suit immédiatement une séquence de cinq bits consécutifs de valeur 1 est censé représenter un bit de bourrage.

De préférence, une variable d'état est associée à chaque hypothèse de chemin, qui est mise à jour, au fur et à mesure que l'hypothèse de chemin est construite, en fonction de la partie déjà construite de l'hypothèse de chemin. On surveille alors la variable d'état pour déterminer si les conditions selon lesquelles l'insertion d'un bit de bourrage est effectuée sont remplies. Par exemple, cette variable d'état peut indiquer pour chaque hypothèse de chemin le nombre de bits consécutifs de la même valeur. Dans l'exemple où l'insertion d'un bit de bourrage a lieu derrière une séquence continue de cinq bits de valeur 1, il convient de surveiller lors de la progression d'une hypothèse de chemin à travers le treillis une variable qui indique combien de bits de valeur 1 ont précédé immédiatement le bit actuel. Dès que cette variable atteint la valeur 5, on déduit que le bit actuel est un bit de bourrage et on choisit la transition conditionnelle correspondante.

Un mode de réalisation préféré du procédé de l'invention s'applique à des messages dont la génération comprend, comme transformation du message initial, le calcul d'un bloc de contrôle de redondance cyclique qui est assemblé au message initial et un codage (p.ex. un codage canal) du message transformé après insertion des bits de bourrage. Selon ce mode de réalisation préféré, la sélection du chemin à travers le treillis fait partie du décodage. Les noeuds du treillis représentent alors les éléments d'un produit cartésien d'au moins l'ensemble des états d'un encodeur susceptible d'avoir effectué l'encodage et de l'ensemble des états d'un calculateur susceptible d'avoir calculé le bloc de contrôle de redondance cyclique. Dans ce treillis, une transition d'un premier noeud, correspondant à un premier état d'encodeur et un premier état de calculateur, à un second noeud, correspondant à un second état d'encodeur et un second état de calculateur, est possible,

  ◦ en présence d'un bit de message transformé, si

  - par application de ce bit de message transformé à l'encodeur se trouvant dans le premier état d'encodeur, l'encodeur passe au second état d'encodeur, et

  - par application de ce bit de message transformé au calculateur se trouvant dans le premier état de calculateur, le calculateur passe au second état de calculateur,

  ◦ ou, en présence d'un bit de bourrage, si

  - par application de ce bit de bourrage à l'encodeur se trouvant dans le premier état d'encodeur, l'encodeur passe au second état d'encodeur, et

  - le premier état de calculateur est égal au second état de calculateur.

Il sera apprécié que le procédé selon l'invention puisse être utilisé pour la correction de messages AIS. La séquence d'observation est alors obtenue à partir d'un signal AIS, par exemple reçu par un satellite, notamment par un satellite en orbite basse. Le signal AIS est éventuellement reçu en collision avec d'autres signaux AIS (c.-à-d. qui sont reçus simultanément ou qui se chevauchent dans le temps). Dans ce cas, le procédé selon l'invention est avantageusement combiné avec des méthodes de « décollision » et de démodulation des signaux AIS, par exemple la méthode SIC (de l'anglais « Successive Interference Cancellation ») ou la formation de faisceau déterministe ou adaptative. Une méthode pour générer plusieurs « candidats de message AIS » à partir de signaux AIS en collision est décrite dans le document US 2008/0304597. Ces candidats pourraient être utilisés en tant que séquences d'observation dans le procédé selon l'invention. Notons aussi que ce dernier peut être utilisé au niveau d'un récepteur à bord d'un satellite ou au sol.

Un aspect de l'invention concerne un programme d'ordinateur contenant des instructions entraînant la mise en oeuvre du procédé décrit ci-dessus lorsque le programme d'ordinateur est exécuté par un ordinateur. Le programme d'ordinateur peut faire partie d'un produit de programme d'ordinateur qui comprend un support de données (p.ex. un disque dur, une mémoire flash, une clé USB, un CD, un DVD, une mémoire vive, etc.) sur lequel le programme est stocké.

Un autre aspect de l'invention concerne un décodeur configuré, p.ex. à l'aide d'un programme d'ordinateur approprié, pour la mise en oeuvre du procédé de l'invention.

**Brève description des dessins**

D'autres particularités et caractéristiques de l'invention ressortiront de la description détaillée de quelques modes de réalisation avantageux présentés ci-dessous, à titre d'illustration, avec référence aux dessins annexés. Ceux-ci montrent:

Fig. 1: un schéma de principe d'une chaîne de transmission de messages conventionnelle ;

Fig. 2 : un schéma de principe d'une chaîne de transmission de messages conventionnelle avec codage en treillis du côté de l'émetteur et décodage du côté du récepteur ;

Fig. 3: une illustration de l'insertion de bits de bourrage ;

Fig. 4: un schéma simplifié d'un décodeur pour mettre en oeuvre le procédé selon une première variante de l'invention ;

Fig. 5: une représentation d'un treillis CRC à quatre états ;

Fig. 6 une représentation du treillis CRC de la figure 4 avec des branches supplémentaires correspondant à des transitions conditionnelles ;

Fig. 7 une illustration de la mise à jour de variables d'état P et S utilisées respectivement pour détecter un bit de bourrage et indiquer le nombre total de bits de bourrage rencontrés ;

Fig. 8 une illustration de l'étape de décision si une transition conditionnelle de bit de bourrage doit être empruntée ou non ;

Fig. 9 : un schéma simplifié d'un décodeur pour mettre en oeuvre le décodage, la suppression de bits de bourrage et la correction du message transmis ;

Fig. 10 : une illustration de la construction d'un treillis étendu ;

Fig. 11 : un treillis CRC et un treillis de codage ;

Fig. 12 : une illustration de la construction des hypothèses de chemin à travers le treillis étendu associé aux treillis CRC et de codage de la figure 11 ;

Fig. 13: une illustration de la construction d'un treillis étendu avec transitions associées à la réception d'un bit de bourrage (transitions conditionnelles) ;

Fig. 14 : un schéma de principe du côté émetteur d'une chaîne de transmission AIS ;

Fig. 15 : une représentation graphique du taux d'erreurs de paquets (PER) simulé en fonction du rapport signal à bruit pour un récepteur GMSK optimal et pour un récepteur utilisant le procédé selon l'invention ;

Fig. 16 : une représentation graphique du taux d'erreurs binaires (BER) simulé en fonction du rapport signal à bruit pour un récepteur GMSK optimal et pour un récepteur utilisant le procédé selon l'invention.

### Description d'exécutions préférées

### Variante sans codage treillis

La figure 4 montre un schéma très simplifié d'un décodeur 30 pour mettre en oeuvre le procédé selon une première variante de l'invention. Ce décodeur 30 est destiné à remplacer les étages de suppression des bits de bourrage 22 et de vérification du CRC 24 dans la chaîne de transmission conventionnelle montrée à la figure 1.

Dans la suite, nous supposerons que l'insertion de bits de bourrage est effectuée comme selon le protocole HDLC, c.-à-d. qu'un bit de bourrage de valeur 0 est inséré immédiatement après chaque séquence de cinq bits consécutifs de valeur 1. Notons que ce choix est fait uniquement afin de pouvoir illustrer l'invention dans le cadre d'un exemple concret. L'homme du métier n'aura aucune difficulté à adapter le procédé de l'invention à d'autres schémas d'insertion de bits de bourrage.

Un bloc de CRC peut être calculé de manière itérative au moyen d'un registre à décalage à rétroaction linéaire associé au polynôme générateur. Le registre est initialisé (normalement avec la séquence [00...0] ou [11...1], bien que tout autre état initial du registre puisse être convenu par protocole). Le message initial est appliqué bit par bit au registre, suivi par autant de zéros que le registre contient de cellules. L'état final ainsi obtenu correspond au bloc de CRC, qui est rattaché au message initial. Les états intermédiaires du calculateur de CRC (le registre à décalage à rétroaction linéaire associé au polynôme générateur du CRC) peuvent être considérés représenter des états (noeuds) d'un treillis. Ces états sont interconnectés par des transitions (branches) qui relient un premier état de calculateur de CRC à un second état de calculateur auquel on arrive en appliquant un nouveau bit en entrée du calculateur lorsque celui-ci se trouve dans le premier état.

La figure 5 montre un treillis CRC dans le cas où le calculateur de CRC est à quatre états différents, numérotés 0, 1, 2 et 3. Les flèches partant de chaque état correspondent aux branches du treillis et indiquent l'état suivant du calculateur de CRC selon que le bit y appliqué est zéro ou un.

A la réception d'une séquence d'observation, fournie par exemple par un démodulateur, on peut corriger des erreurs de transmission à l'aide de l'algorithme de Viterbi : on construit une pluralité d'hypothèses de chemin à travers le treillis CRC, parmi lesquelles on sélectionne l'hypothèse de chemin la plus probable par rapport à la séquence d'observation. Or cette approche ne fonctionne pas si des bits de bourrage ont été insérés dans le message transformé (le message initial suivi de son bloc de CRC), étant donné que le bloc de CRC rattaché au message initial ne tient pas compte d'éventuels bits de bourrage insérés après.

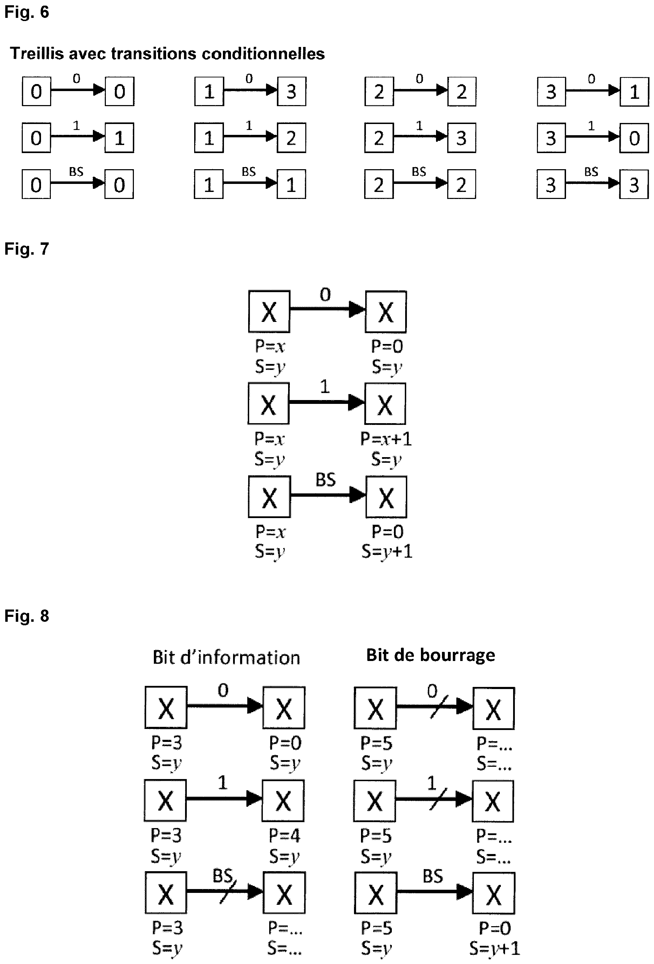

Dans le cadre de l'invention, il est donc proposé de modifier le treillis CRC pour pouvoir corriger un message à l'aide de l'algorithme de Viterbi ou l'algorithme SOVA même en présence de bits de bourrage insérés après le calcul et le rattachement du bloc de CRC. Pour cela on rajoute des transitions conditionnelles entre les états du calculateur de CRC, qui ne sont empruntables qu'en présence d'un bit de bourrage. La figure 6 montre le treillis de la figure 5 auquel on a rajouté les transitions conditionnelles. Contrairement à la figure 5, la figure 6 montre les transitions entre à chaque fois deux états de manière individuelle. Les transitions conditionnelles ne sont empruntées que dans le cas d'un bit de bourrage (noté *BS* pour bit de « stuffing »). Elles relient chaque état à lui-même, ce qui reflète que le bit de bourrage n'entraîne pas de changement d'état du calculateur de CRC. Ainsi, lorsque au cours de la construction d'hypothèses de chemin à travers le treillis un bit de bourrage est détecté, seule la transition conditionnelle d'un bit de bourrage peut être empruntée. Comme l'état du calculateur de CRC ne change pas dans le cas d'un bit de bourrage, ceci revient à ignorer les bits identifiés comme étant des bits de bourrage au cours de la construction des hypothèses de chemin.

Afin de surveiller l'apparition de bits de bourrage au cours de la construction d'une hypothèse de chemin, on introduit une variable d'état $P(k, X)$ associée à chaque état $X$ (dans l'exemple, $X = 0$, 1, 2 ou 3) à « l'instant » $k$. $k$ indique le nombre d'états (de noeuds) parcourus sur le treillis avant d'arriver à l'état considéré via l'hypothèse de chemin survivante. $P(k, X)$ indique le nombre de bits consécutifs de valeur *1* reçus immédiatement avant d'atteindre l'état $X$ à l'instant $k$. Une autre variable d'état $S(k, X)$ est introduite qui indique le nombre total de bits de bourrage rencontrés sur le treillis avant d'arriver à l'instant $k$ à l'état $X$ via l'hypothèse de chemin survivante. Le nombre $S$ de l'hypothèse de chemin finalement retenue permettra de déduire le nombre de bits d'information et de CRC reçus. La figure 7 montre l'évolution des variables $P$ et $S$ dans les trois situations qui peuvent survenir. Si le bit reçu est un bit d'information ou de CRC de valeur 0, la variable $P$ est remise à zéro pour l'état atteint ; $S$ reste inchangée. Si le bit reçu est un bit d'information ou de CRC de valeur 1, la variable $P$ est augmentée d'une unité pour l'état atteint et $S$ reste de nouveau inchangée. Si le bit reçu est un bit de bourrage, $P$ est remise à zéro pour l'état atteint tandis que $S$ est augmentée d'une unité.

Au cours de la construction d'une hypothèse de chemin, la variable $P$ indique si le prochain bit est un bit d'information (ou de CRC) ou de bourrage. Dans notre exemple, un bit est un bit bourrage à la condition nécessaire et suffisante que ce bit soit immédiatement précédé d'une séquence ininterrompue de cinq bits d'information ou de CRC de valeur 1. Si la variable $P$ atteint 5 dans un noeud d'une hypothèse de chemin (à droite sur la figure 8), la prochaine transition doit être une transition associée à un bit de bourrage. Les transitions associées à un bit d'information ou de CRC sont alors impossibles. Si par contre $P < 5$ dans un noeud d'une hypothèse de chemin (à gauche sur la figure 8), la prochaine transition doit être une transition associée à un bit d'information ou de CRC. La transition associée à un bit de bourrage est impossible à partir de cet état. A la figure 8, les transitions impossibles sont barrées. En pratique, on peut exprimer l'impossibilité d'une transition en lui affectant une distance « infinie ». Une hypothèse de chemin que l'on prolonge par une transition à distance infinie dans l'algorithme de Viterbi ne pourra pas survivre et sera éliminée.

Pour finalement choisir parmi les hypothèses de chemin survivantes l'hypothèse de chemin la plus probable par rapport à la séquence d'observation, on peut utiliser la propriété : *CRC([données, CRC(données)]) = 0*. Il en découle que l'hypothèse de chemin à sélectionner doit aboutir à l'état [00...0] du calculateur de CRC.

### Variante avec codage en treillis

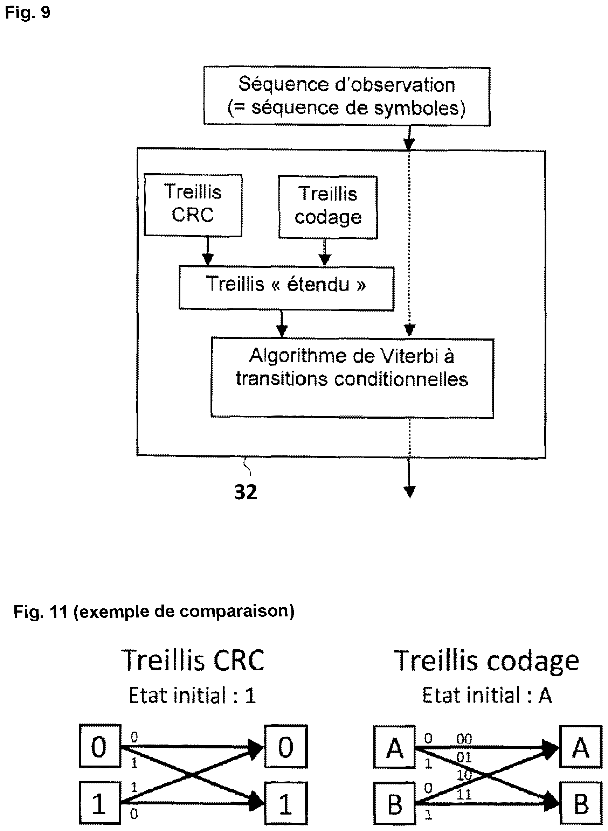

La figure 9 montre un schéma très simplifié d'un décodeur 32 pour mettre en oeuvre le procédé selon une deuxième variante de l'invention. Ce décodeur 32 est destiné à remplacer les étages de décodage 21, de suppression des bits de bourrage 22 et de vérification du CRC 24.

Ce mode de réalisation du procédé utilise pour le décodage, la suppression de bits de bourrage et la vérification de CRC un treillis « étendu » qui correspond au treillis d'une machine à états finis comprenant l'encodeur et le calculateur de CRC, et dans laquelle, l'encodeur et le calculateur de CRC sont alimentés par la même entrée, c.-à-d. changent d'états en fonction de la même séquence binaire appliquée en entrée.

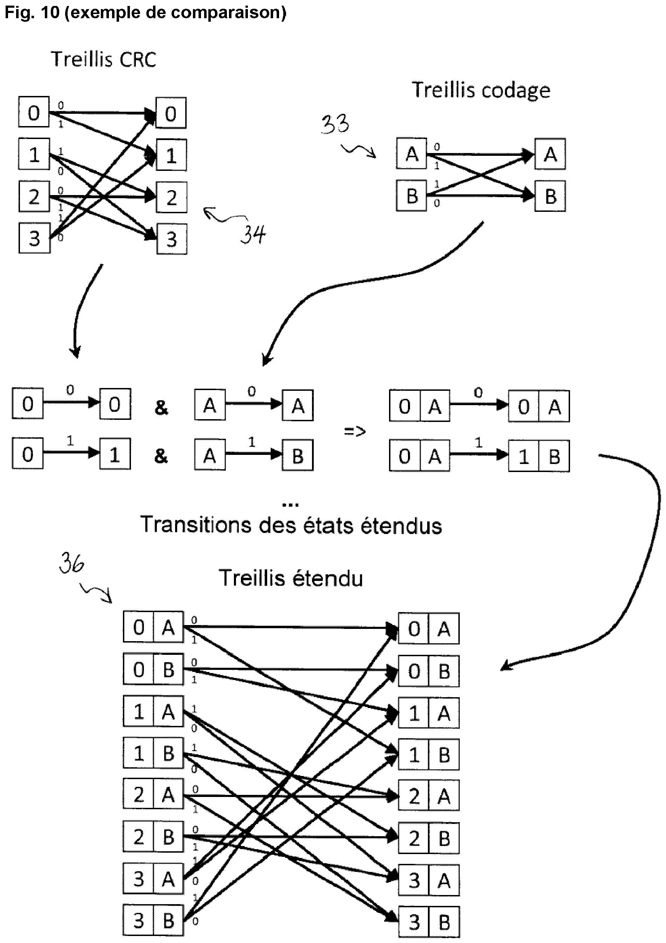

Afin de faire comprendre au mieux ce procédé et le concept du treillis étendu, le procédé sera d'abord expliqué, à l'aide des figures 10-12, pour le cas où l'insertion de bits de bourrage ne serait pas prévue dans le protocole de transmission.

**Exemple de comparaison sans suppression de bits de bourrage**

Le procédé utilise un treillis « étendu » dont les noeuds ne représentent pas seulement les différents états de l'encodeur mais aussi les états du calculateur du bloc de CRC. Il est bien connu d'utiliser, p.ex. dans le contexte de l'algorithme de Viterbi, un treillis représentant les états et les transitions de l'encodeur. Par contre, à la connaissance de l'inventeur, un treillis associé au calculateur de CRC (en bref « treillis CRC ») n'a jusqu'ici jamais été utilisé dans le cadre du décodage d'une séquence de symboles et de la correction d'erreurs de transmission y relative. Il convient donc d'expliquer ce qu'on entend par « treillis CRC ».

Un bloc de CRC peut être calculé de manière itérative au moyen d'un registre à décalage à rétroaction linéaire associé au polynôme générateur. Le registre est initialisé (normalement avec la séquence [00...0] ou [11...1], bien que tout autre état initial du registre puisse être convenu par protocole). Le message initial est appliqué bit par bit au registre, suivi par autant de zéros que le registre contient de cellules. L'état final ainsi obtenu correspond au bloc de CRC, qui est rattaché au message initial. Les états intermédiaires du calculateur de CRC (le registre à décalage à rétroaction linéaire associé au polynôme générateur du CRC) peuvent être censés représenter des états (noeuds) du treillis CRC. Ces états sont interconnectés par des transitions (branches) qui relient un premier état de calculateur de CRC à un second état de calculateur auquel on arrive en appliquant un nouveau bit en entrée du calculateur lorsque celui-ci se trouve dans le premier état.

La figure 10 est une illustration de la construction d'un treillis étendu 36 à partir d'un treillis de codage 33 et d'un treillis CRC 34. Le treillis CRC 34 correspond à un cas où le calculateur de CRC peut se trouver dans quatre états différents, numérotés 0, 1, 2 et 3. Les flèches partant de chaque état correspondent aux branches du treillis CRC et indiquent l'état suivant du calculateur de CRC selon que le bit y appliqué en entrée est zéro ou un. Le treillis de codage 33 est à deux états.

Le treillis «étendu» correspond au produit cartésien $\{(0 ; A), (0 ; B), (1 ; A),..., (3 ; B)\}$ de l'ensemble des noeuds du treillis CRC $\{0, 1, 2, 3\}$ et de l'ensemble des noeuds du treillis de codage $\{A, B\}$. Une transition d'un premier noeud $(\alpha ; X)$, correspondant à un premier état de calculateur $\alpha \in \{0, 1, 2, 3\}$ et un premier état d'encodeur $X \in \{A, B\}$, à un second noeud $(\beta ; Y)$, correspondant à un second état de calculateur $\beta \in \{0, 1, 2, 3\}$ et un second état d'encodeur $Y \in \{A, B\}$ est possible si les transitions $\alpha \to \beta$ et $X \to Y$ du treillis CRC, respectivement du treillis de codage, sont engendrées par le même bit (0 ou 1) appliqué en entrée. P.ex. si l'état $Y$ (respectivement $Z$) du treillis de codage suit à l'état $X$ lorsque le bit transmis est 0 (respectivement 1) et l'état $\beta$ (respectivement $\gamma$) du treillis CRC suit à l'état $\alpha$ lorsque le bit transmis est 0 (respectivement 1), alors l'état $(\beta ; Y)$ (respectivement $(\gamma ; Z)$) suit à l'état $(\alpha ; X)$ lorsque le bit transmis est 0 (respectivement 1). Sur la figure 10, le bit qui engendre une transition est à chaque fois placé près de la flèche qui la représente.

Le nombre d'états du treillis étendu s'élève au produit des nombres de noeuds du treillis de codage et du treillis CRC. Notamment le treillis CRC peut présenter un nombre très élevé de noeuds. Il existe, p.ex. des blocs de CRC à 64 bits, ce qui correspond à un treillis CRC avec $2^{64}$ états possibles.

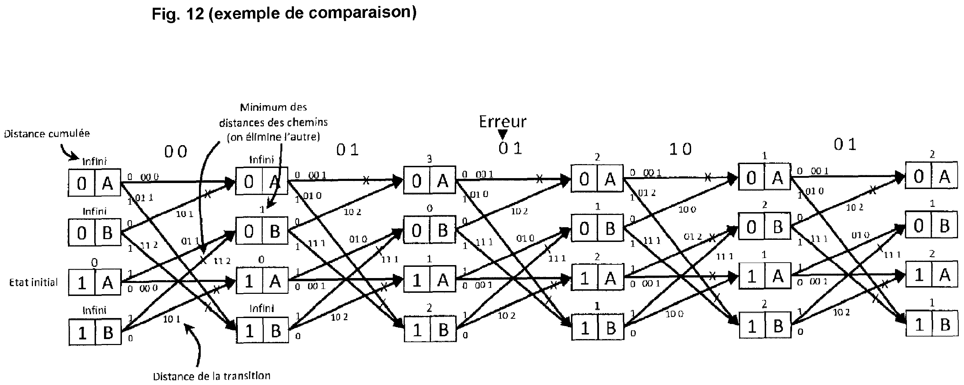

Pour expliquer le déroulement d'un mode de réalisation du procédé inventif basé sur l'algorithme de Viterbi, le CRC le plus court possible (1 bit) a été choisi afin de pouvoir graphiquement illustrer la construction des hypothèses de chemin à travers le treillis (voir figure 12). Les treillis de CRC et de codage choisis dans l'exemple sont montrés à la figure 11.

On suppose que le message initial est représenté par la séquence binaire [011 0]. Le bloc de CRC calculé pour ce message initial est [1]. Ce bloc de CRC correspond au bit de parité, qui indique si le nombre de uns dans le message initial est pair. Le paquet de données (message transformé) obtenu par concaténation du message initial et du bloc de CRC est [0 1 1 0 1].

Par application du treillis de codage de la figure 11, le codage de [0 1 1 0 1] donne la séquence de symboles [00 01 11 10 01]. On ajoute une erreur d'un bit au niveau du troisième symbole pour illustrer que la correction se fait. La séquence de symboles à l'entrée du décodeur est présumée être [00 01 01 10 01].

La figure 12 montre la construction des hypothèses de chemin à travers le treillis étendu selon l'algorithme de Viterbi. Les états initiaux du calculateur de CRC et de l'encodeur sont connus au décodage. On peut donc dès le départ exclure les hypothèses de chemin qui ne prennent pas le départ à l'état $(1 ; A)$. Alternativement, on attribue aux hypothèses de chemin prenant le départ à un état différent de l'état initial une distance infinie (solution retenue dans la représentation de la figure 12). De cette manière, on s'assure que ces hypothèses de chemin seront éliminées lors de la progression à travers le treillis. La figure 12 montre à côté de chaque transition le symbole auquel correspond cette transition.

L'indication de symbole est suivie de la distance (de Hamming) entre le symbole observé et le symbole auquel correspond la transition. A chaque fois que des hypothèses de chemin arrivent au même noeud du treillis, seule celle qui présente la distance cumulée la plus basse survit. Les autres hypothèses de chemin sont éliminées. A la figure 12, les hypothèses de chemin éliminées sont marquées par une croix et la distance cumulée de l'hypothèse de chemin survivante est notée au-dessus du noeud concerné. Dans la suite, on note $\Gamma(k, (\alpha; X))$ la distance cumulée à l'état $(\alpha ; X)$ à l'instant $k$.

Quand l'état final est atteint, on sélectionne l'hypothèse de chemin avec la distance minimale. On note que dans le cas de l'exemple les hypothèses de chemin arrivant aux noeuds $(0 ; B)$ et $(1 ; B)$ possèdent la même distance minimale 1. Ici, on utilise la propriété : *CRC([données, CRC(données)])* = 0, puisqu'il découle de celle-ci que l'état final du calculateur de CRC doit être 0. On retient donc l'hypothèse de chemin aboutissant à l'état $(0 ; B)$. Le message trouvé est donc [0 1 1 0 1]. L'erreur de transmission a été corrigée.

**Variante avec suppression de bits de bourrage**

Le procédé de l'exemple qui vient d'être discuté ne saurait être appliqué sans modifications dans le cas où des bits de bourrage auraient été insérés après le calcul du bloc de CRC.

Pour tenir compte de la présence (éventuelle) de bits de bourrage, des transitions spéciales sont introduites dans le treillis étendu. Ces transitions sont empruntées lorsqu'un bit de bourrage est reçu et sont définies de manière à ce que les bits de bourrage soient pris en compte au même titre que les bits d'information ou de CRC pour la succession des états de l'encodeur tandis que l'état du calculateur de CRC reste inchangé lorsque le bit reçu est un bit de bourrage.

Dans la suite, nous supposerons que l'insertion de bits de bourrage est effectuée comme le prévoit le protocole HDLC, c.-à-d. qu'un bit de bourrage de valeur 0 est inséré immédiatement après chaque séquence de cinq bits consécutifs de valeur 1. Notons que ce choix est fait uniquement afin de pouvoir illustrer l'invention dans le cadre d'un exemple concret. L'homme du métier n'aura aucune difficulté à adapter le procédé de l'invention à d'autres schémas d'insertion de bits de bourrage.

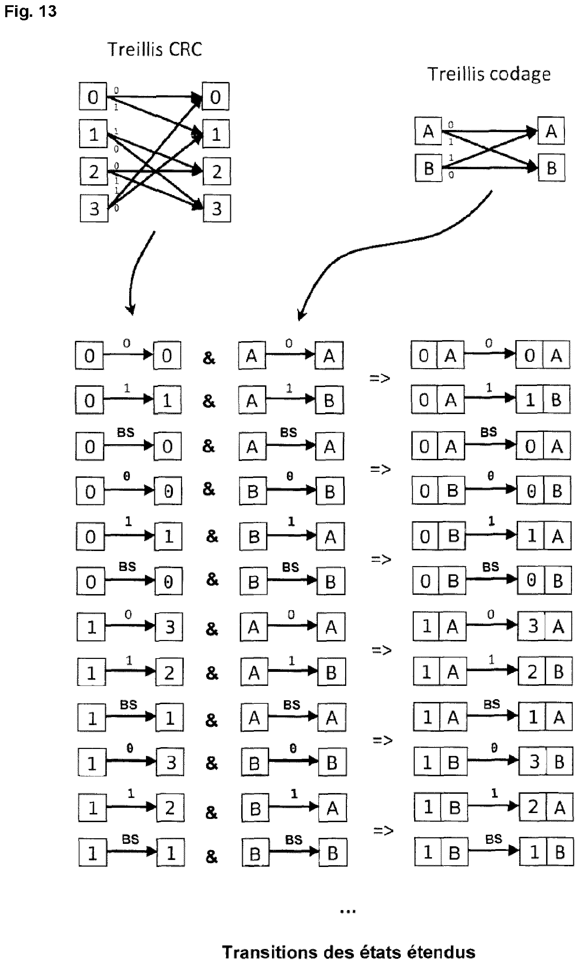

La construction d'un treillis étendu à transitions conditionnelles de bits de bourrage à partir d'un treillis CRC et d'un treillis de codage est illustrée à la figure 13. Les treillis de CRC et de codage sont les mêmes qu'à la figure 10. L'ensemble des noeuds du treillis étendu correspond à nouveau au produit cartésien $\{(0 ; A), (0 ; B), (1 ; A),..., (3 ; B)\}$ de l'ensemble des noeuds du treillis CRC $\{0, 1, 2, 3\}$ et de l'ensemble des noeuds du treillis de codage $\{A, B\}$. On peut maintenant distinguer les transitions associées aux bits d'information ou de CRC (du paquet de données) des transitions conditionnelles associées aux bits de bourrage. Les transitions associées aux bits d'information ou de CRC sont les mêmes qu'à la figure 10. Une transition associée à un bit d'information ou de CRC d'un premier noeud $(\alpha ; X)$, correspondant à un premier état de calculateur $a \in \{0, 1, 2, 3\}$ et un premier état d'encodeur $X \in \{A, B\}$, à un second noeud $(\beta ; Y)$, correspondant à un second état de calculateur $\beta \in \{0, 1, 2, 3\}$ et un second état d'encodeur $Y \in \{A, B\}$ est possible si les transitions $\alpha \to \beta$ et $X \to Y$ du treillis CRC, respectivement du treillis de codage, sont engendrées par le même bit d'information ou de CRC (0 ou 1) appliqué en entrée. Une transition associée à un bit de bourrage *BS* d'un premier noeud $(\alpha ; X)$, correspondant à un premier état de calculateur $\alpha \in \{0, 1, 2, 3\}$ et un premier état d'encodeur $X \in \{A, B\}$, à un second noeud $(\beta ; Y)$, correspondant à un second état de calculateur $\beta \in \{0, 1, 2, 3\}$ et un second état d'encodeur $Y \in \{A, B\}$ est possible si $\alpha = \beta$ et si la transition $X \to Y$ du treillis de codage est possible pour un bit d'information ou de CRC ayant la même valeur que le bit de bourrage *BS*. Si l'insertion de bits de bourrage est effectuée comme prévu dans le protocole HDLC, tous les bits de bourrage auront la valeur 0.

Si l'état $Y$ (respectivement $Z$) du treillis de codage suit à l'état $X$ lorsque le bit transmis est un bit d'information ou de CRC de valeur 0 (respectivement 1) et l'état $\beta$ (respectivement $\gamma$) du treillis CRC suit à l'état $\alpha$ lorsque le bit transmis est un bit d'information ou de CRC de valeur 0 (respectivement 1), alors l'état $(\beta ; Y)$ (respectivement $(\gamma ; Z)$) suit à l'état $(\alpha ; X)$ lorsque le bit transmis est un bit d'information ou de CRC de valeur 0 (respectivement 1). Ceci peut s'écrire :

$$\alpha \xrightarrow{\;0\;} \beta \ \text{ et } \ X \xrightarrow{\;0\;} Y \Rightarrow (\alpha ; X) \xrightarrow{\;0\;} (\beta ; Y)$$

$$\alpha \xrightarrow{\;1\;} \gamma \ \text{ et } \ X \xrightarrow{\;1\;} Z \Rightarrow (\alpha ; X) \xrightarrow{\;1\;} (\gamma ; Z)$$

En présence d'un bit de bourrage *BS* (de valeur 0) on a dans ce cas les transitions :

$$\alpha \xrightarrow{\;BS\;} \alpha \ \text{ et } \ X \xrightarrow{\;BS\;} Y \Rightarrow (\alpha ; X) \xrightarrow{\;BS\;} (\alpha ; Y).$$

Les transitions conditionnelles ne sont empruntées dans le treillis que si un bit de bourrage est reçu. Afin de surveiller l'apparition de bits de bourrage au cours de la construction d'une hypothèse de chemin, on introduit une variable d'état $P(k, (\alpha\,;X))$ associée à chaque état $(\alpha\,;X)$ (dans l'exemple, $\alpha = 0, 1, 2$ ou $3$ et $X = A$ ou $B$) à « l'instant » $k$. $k$ indique le nombre d'états (de noeuds) parcourus sur le treillis avant d'arriver à l'état considéré via l'hypothèse de chemin survivante. $P(k,(\alpha\,;X))$ indique le nombre de bits consécutifs de valeur 1 reçus immédiatement avant d'atteindre l'état $(\alpha\,;X)$ à l'instant $k$. Une autre variable d'état $S(k, (\alpha\,;X))$ est introduite qui indique le nombre total de bits de bourrage rencontrés sur le treillis avant d'arriver à l'instant $k$ à l'état $(\alpha\,;X)$ via l'hypothèse de chemin survivante. Le nombre $S$ de l'hypothèse de chemin finalement retenue permettra de déduire le nombre de bits d'information et de CRC reçus.

| $k$ | Bit reçu | $k + 1$ |
|---|---|---|
| $(\alpha\,;X)$ <br> $P_k < 5$, $S_k$ | $\xrightarrow{\,0\,}$ | $(\beta\,;Y)$ <br> $P_{k+1} = 0$, $S_{k+1} = S_k$ |
| $(\alpha\,;X)$ <br> $P_k < 5$, $S_k$ | $\xrightarrow{\,1\,}$ | $(\gamma\,;Z)$ <br> $P_{k+1} = P_k + 1$, $S_{k+1} = S_k$ |
| $(\alpha\,;X)$ <br> $P_k < 5$, $S_k$ | $\xrightarrow{\,BS\,}$ <br> impossible ! | $(\alpha\,;Y)$ |
| $(\alpha\,;X)$ <br> $P_k = 5$, $S_k$ | $\xrightarrow{\,0\,}$ <br> impossible ! | $(\beta\,;Y)$ |
| $(\alpha\,;X)$ <br> $P_k = 5$, $S_k$ | $\xrightarrow{\,1\,}$ <br> impossible ! | $(\gamma\,;Z)$ |
| $(\alpha\,;X)$ <br> $P_k = 5$, $S_k$ | $\xrightarrow{\,BS\,}$ | $(\alpha\,;Y)$ <br> $P_{k+1} = 0$, $S_{k+1} = S_k + 1$ |

Le tableau ci-dessus montre l'évolution des variables $P$ et $S$ dans les situations qui peuvent survenir. Si le bit reçu est un bit d'information ou de CRC de valeur 0, la variable $P$ est remise à zéro pour l'état atteint ; $S$ reste inchangée. Si le bit reçu est un bit d'information ou de CRC de valeur 1, la variable $P$ est augmentée d'une unité pour l'état atteint et $S$ reste de nouveau inchangée. Si le bit reçu est un bit de bourrage ($P = 5$), $P$ est remise à zéro pour l'état atteint tandis que $S$ est augmentée d'une unité.

Au cours de la construction d'une hypothèse de chemin à travers le treillis étendu, la variable $P$ indique si le prochain bit est un bit d'information (ou de CRC) ou de bourrage. Dans notre exemple, un bit est détecté comme étant un bit de bourrage à la condition nécessaire et suffisante que ce bit soit immédiatement précédé d'une séquence ininterrompue de cinq bits d'information ou de CRC de valeur 1. Si la variable $P$ atteint 5 dans un noeud d'une hypothèse de chemin, la prochaine transition doit être une transition associée à un bit de bourrage. Les transitions associées à un bit d'information ou de CRC sont alors impossibles. Si par contre $P < 5$ dans un noeud d'une hypothèse de chemin, la prochaine transition doit être une transition associée à un bit d'information ou de CRC. La transition associée à un bit de bourrage est impossible à partir de cet état. En pratique, on peut exprimer l'impossibilité d'une transition en lui affectant une distance « infinie ». Une hypothèse de chemin que l'on prolonge par une transition à distance infinie dans l'algorithme de Viterbi ne pourra pas survivre et sera éliminée.

Pour choisir l'hypothèse de chemin la plus probable, on peut à nouveau utiliser la propriété que l'état final du calculateur de CRC est 0. Par contre, l'état final $\theta_{TC}^{f}$ de l'encodeur ainsi que le nombre de bits (d'information, de CRC et de bourrage) $K$ du message transmis sont a priori inconnus. On note $\hat{K}$ et $\hat{\theta}_{TC}^{f}$ les valeurs de $K$, respectivement de $\theta_{TC}^{f}$, parmi les valeurs de $K$ et de $\theta_{TC}^{f}$ possibles, qui conjointement minimisent la distance $\Gamma(K, (0\,;\theta_{TC}^{f}))$ :

$$(\hat{K}, \hat{\theta}_{TC}^{f}) = \arg\min_{K, \theta_{TC}^{f}} \Gamma(K, (0\,;\theta_{TC}^{f}))$$

avec la contrainte : $S_{\min} \leq S(K, (0 ; \theta_{TC}^f)) \leq S_{\max}$ et $N_{\min} \leq K - S(K, (0 ; \theta_{TC}^f)) \leq N_{\max}$, où $S_{\min}$ et $S_{\max}$ désignent respectivement le nombre minimal et le nombre maximal de bits de bourrage, et $N_{\min}$ et $N_{\max}$ respectivement le nombre minimal et le nombre maximal de bits d'information et de CRC. Ces nombres sont définis dans le cadre de l'application. P.ex., pour AIS, $S_{\min} = 0$ et $S_{\max} = 4$ et $N_{mm} = N_{\max} = 184$. $\hat{K}$ peut prendre n'importe quelle valeur entre le nombre de bits minimal $K_{\min} = N_{\min} + S_{\min}$ et le nombre de bits maximal de bits maximal $K_{\max} = N_{\max} + S_{\max}$.

**Exemple de programme d'ordinateur**

Un code source de programme d'ordinateur pour la mise en oeuvre du procédé selon le précédent exemple est brièvement présenté dans la suite. Les extraits de programme d'ordinateur auxquels est fait référence figurent en annexe à la fin de la description.

Le premier extrait du programme concerne l'initialisation de variables. Dans le cadre du programme, $(A ; \alpha)$ désigne l'état initial du treillis étendu. $A$ (= état initial du calculateur de CRC) est initialisé conformément au protocole de communication. Dans le cas d'AIS, qui utilise du CRC-16, $A$ est initialisé à $2^{16} - 1$. La distance $\Gamma(0, (A ; \alpha))$ est mise à zéro pour toute valeur possible de $\alpha$ (= état initial du codeur) si $\alpha$ est inconnue. Si $\alpha$ est connue, on pose: $\Gamma(0,(A;\alpha)) = 0$. La variable d'état $R(k, (\theta_{CRC} ; \theta_{TC}))$ correspond au bit $(0, 1,$ ou $BS)$ associé à la dernière transition à l'instant $k$ de l'hypothèse de chemin survivante au noeud $(\theta_{CRC} ; \theta_{TC})$.

Dans le deuxième extrait du programme, les variables de transition sont mises à jour pour chaque symbole reçu.

$x_k$ désigne le symbole reçu à l'instant $k$, $N_s$ le nombre de symboles possibles, $S_s$ le $s$-ième symbole (des $N_s$ symboles possibles), $Distance(x_k, S_s)$ est la distance entre le symbole reçu à l'instant $k$ et le symbole $S_s$. $\theta_{CRC}$ et $\theta_{TC}$ sont les états du calculateur du bloc de CRC, respectivement de l'encodeur. $N_{CRC}$ représente le nombre d'états possibles du treillis de CRC et $N_{TC}$ le nombre d'états possibles du treillis de codage. $NextS(\theta_{TC}, t)$ renvoie au numéro $(s)$ du symbole lorsque l'encodeur se trouve dans l'état $\theta_{TC}$ et un bit $t$ est reçu ($t$ peut prendre les valeurs 0, 1, ou $BS$). La variable de transition $\Gamma_{trans}((\theta_{CRC};\theta_{TC}),t)$ est définie à l'instant $k$ comme la somme de $\Gamma(k-1,(\theta_{CRC};\theta_{TC}))$ et la distance entre le symbole reçu à l'instant $k$ et le symbole correspondant à la transition qui part de l'état $(\theta_{CRC} ; \theta_{TC})$ et qui est associée au bit $t$. La variable de transition $S_{trans}(\theta_{CRC} ; \theta_{TC})$ est définie à l'instant $k$ comme $S(k - 1, (\theta_{CRC} ; \theta_{TC}))$ incrémentée de un si un bit de bourrage est reçu après l'état $(\theta_{CRC} ; \theta_{TC})$ à l'instant $k$. La variable de transition $P_{trans}((\theta_{CRC} ; \theta_{TC}), t)$ est définie à l'instant $k$ comme $P(k - 1, (\theta_{CRC} ; \theta_{TC}))$ incrémentée de un lorsque que l'état $(\theta_{CRC} ; \theta_{TC})$ est suivi par un bit à un $(t = 1)$ à l'instant $k$. Dans le cas où le bit reçu n'est pas un bit de bourrage $(t \neq BS)$, les variables de transition sont mises à jour comme dans l'algorithme de Viterbi conventionnel. Dans le cas contraire, seules les transitions conditionnelles restent possibles (une distance infinie est affectée aux transitions associées à un bit d'information ou de CRC).

La troisième partie du programme s'occupe du calcul des variables d'état. La fonction $Prev\theta_{CRC}(\theta_{CRC}, t)$ renvoie à l'état de calculateur de CRC qui précède l'état $\theta_{CRC}$ si le bit $t$ est reçu. La fonction $Prev\theta_{TC}(\theta_{TC}, t)$ renvoie à l'état de l'encodeur suivi par l'état $\theta_{TC}$ si le bit $t$ est reçu.

Dans le quatrième extrait, l'hypothèse de chemin optimale est retracée à travers le treillis étendu. On commence à l'état final estimé $(0 ; \hat{\theta}_{TC}^f)$ et on détermine de manière itérative les états précédents en empruntant à chaque fois dans le sens inverse la branche de la transition ayant survécu à l'état où on se trouve actuellement. A chaque fois qu'une transition qui correspond à un bit d'information ou de CRC ($t = 0$ ou $1$) est empruntée, le bit correspondant est enregistré dans la variable $U_n$. La séquence $(U_n)$ représente le message décodé duquel les bits de bourrage ont été supprimés.

**Résultats de simulations**

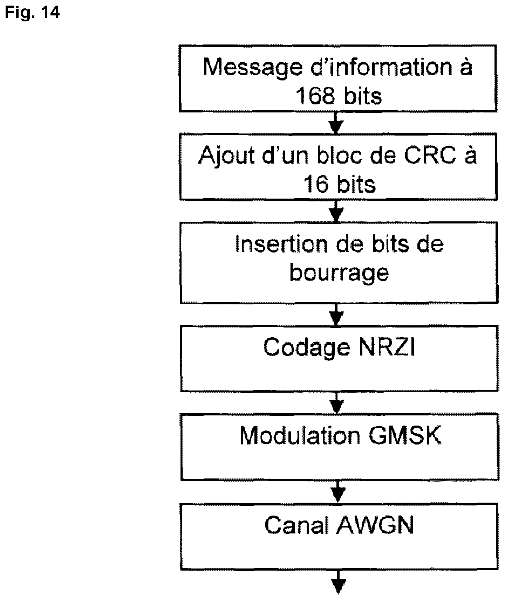

Pour illustrer la performance d'un décodeur mettant en oeuvre le procédé selon l'invention, des simulations ont été menées dans le cas d'une chaîne de transmission AIS telle qu'illustrée à la figure 14. Le message initial a une longueur fixe de 168 bits. Après ajout d'un bloc de CRC-16, des bits de bourrage sont insérés (conformément au protocole AIS après une séquence de cinq bits 1 consécutifs). La trame ainsi obtenue est encodée NRZI (de l'anglais « Non Return to Zero Inverted », codage par différentiel) et modulée GMSK (de l'anglais « Gaussian Minimum Shift Keying » ou modulation à déplacement minimum gaussien) avec les paramètres $BT$ (produit de la bande fréquentielle à -3 dB de la fonction génératrice du filtre gaussien par la période symbole) = 0,3 et $LT$ (demi-longueur du filtre gaussien) = 4. On part de l'hypothèse d'un canal de transmission AWGN (de l'anglais « Additive White Gaussian Noise » pour bruit blanc gaussien additif). Dans cet exemple, le codage NRZI et la modulation GMSK représentent le codage treillis. Selon la recommandation UIT-R M.1371 sur les caractéristiques techniques du système AIS, le polynôme générateur pour le calcul du bloc CRC est $G(x) = x^{16} + x^{12} + x^5 + 1$.

Le décodeur selon l'invention est comparé à un récepteur basé sur un démodulateur GMSK optimal utilisant la démodulation cohérente sur la base de l'algorithme de Viterbi. Dans le décodage NRZI considéré, un changement est associé au bit 0 et le bit 1 est détecté s'il n'y a pas de changement.

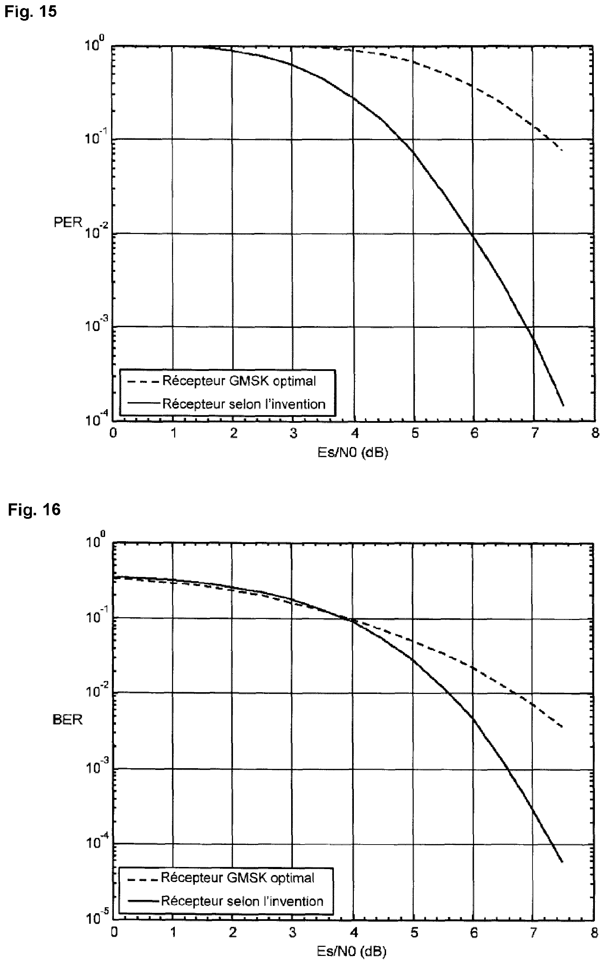

La figure 15 montre le taux d'erreurs de paquets (PER, défini comme le rapport du nombre de paquets erronés, c.-à-d. contenant au moins un bit erroné, au nombre total de paquets transmis) d'un récepteur utilisant un décodeur selon l'invention et d'un récepteur GMSK optimal en fonction du rapport signal sur bruit ($Es/N0$). On remarque que le récepteur proposé présente un gain de plus de 2,5 dB par rapport au récepteur GMSK optimal.

La figure 16 montre le taux d'erreurs binaires (BER, défini comme le rapport du nombre de bits erronés au nombre total de bits transmis pendant un certain laps de temps) d'un récepteur utilisant un décodeur selon l'invention et d'un récepteur GMSK optimal en fonction du rapport signal sur bruit ($Es/N0$). Le taux d'erreur élevé de la figure 16 indique que le taux d'erreur dans des messages erronés est élevé. Autrement dit, lorsqu'un message contient au moins une erreur, il en contient beaucoup en moyenne. Ceci permet d'utiliser des méthodes de vérification de la consistance des données pour déterminer si un message contient des erreurs. Pour détecter des messages erronés, l'utilisation de telles méthodes s'avère utile parce qu'on ne pourra pas se servir du bloc de CRC pour rejeter un message décodé comme erroné. Il est toutefois possible d'inclure dès le départ dans le message initial un bloc de CRC qui ne soit pas utilisé pour la correction des erreurs afin de vérifier après l'exécution du procédé selon l'invention que le message ne contient pas d'erreur. Par contre, ce CRC ne peut utiliser le même polynôme générateur que celui du CRC utilisé pour la correction des erreurs. Sinon, le second CRC sera toujours égal à 0 du fait de l'application de *CRC([données, CRC(données)]) = 0*.

**Extraits de programme d'ordinateur:**

Partie 1 (initialisation)

$$\Gamma(0, (:; :)) \leftarrow \infty$$
$$\Gamma(0, (A; \alpha)) \leftarrow 0$$
$$P(0, (:; :)) \leftarrow 0$$
$$S(0, (:; :)) \leftarrow 0$$
$$R(0, (:; :)) \leftarrow 0$$

Partie 2 (calcul des variables de transition)

$$\textbf{for } s = 1 \textbf{ to } N_S \textbf{ do}$$
$$d(s) \leftarrow Distance(x_k, S_s)$$
$$\textbf{end for}$$
$$\textbf{for } \boldsymbol{\theta}_{TC} = 0 \textbf{ to } N_{TC} - 1 \textbf{ do}$$
$$\Gamma_{trans}((:; \boldsymbol{\theta}_{TC}), 0) \leftarrow d(NextS(\boldsymbol{\theta}_{TC}, 0))$$
$$\Gamma_{trans}((:; \boldsymbol{\theta}_{TC}), 1) \leftarrow d(NextS(\boldsymbol{\theta}_{TC}, 1))$$
$$\textbf{end for}$$
$$\Gamma_{trans}((:; :), 0) \leftarrow \Gamma_{trans}((:; :), 0) + \Gamma(k - 1, (:; :))$$
$$\Gamma_{trans}((:; :), 1) \leftarrow \Gamma_{trans}((:; :), 1) + \Gamma(k - 1, (:; :))$$
$$\Gamma_{trans}((:; :), BS) \leftarrow \infty$$
$$P_{trans}((:; :), 0) \leftarrow 0$$
$$P_{trans}((:; :), 1) \leftarrow P(k - 1, (:; :)) + 1$$
$$P_{trans}((:; :), BS) \leftarrow 0$$
$$S_{trans}((:; :)) \leftarrow S(k - 1, (:; :))$$
$$\textbf{for } \boldsymbol{\theta}_{CRC} = 0 \textbf{ to } N_{CRC} - 1 \textbf{ do}$$
$$\qquad \textbf{for } \boldsymbol{\theta}_{TC} = 0 \textbf{ to } N_{TC} - 1 \textbf{ do}$$
$$\qquad\qquad \textbf{if } P(k - 1, (\boldsymbol{\theta}_{CRC}; \boldsymbol{\theta}_{TC})) = 5 \textbf{ then}$$
$$\qquad\qquad\qquad \Gamma_{trans}((\boldsymbol{\theta}_{CRC}; \boldsymbol{\theta}_{TC}), BS) \leftarrow \Gamma_{trans}((\boldsymbol{\theta}_{CRC}; \boldsymbol{\theta}_{TC}), 0)$$
$$\qquad\qquad\qquad \Gamma_{trans}((\boldsymbol{\theta}_{CRC}; \boldsymbol{\theta}_{TC}), 0) \leftarrow \infty$$
$$\qquad\qquad\qquad \Gamma_{trans}((\boldsymbol{\theta}_{CRC}; \boldsymbol{\theta}_{TC}), 1) \leftarrow \infty$$
$$\qquad\qquad\qquad S_{trans}((\boldsymbol{\theta}_{CRC}; \boldsymbol{\theta}_{TC})) \leftarrow S_{trans}((\boldsymbol{\theta}_{CRC}; \boldsymbol{\theta}_{TC})) + 1$$
$$\qquad\qquad \textbf{end if}$$
$$\qquad \textbf{end for}$$
$$\textbf{end for}$$

Partie 3 (calcul des variables d'état)

$$\mathbf{for}\ \theta_{CRC} = 0\ \text{to}\ N_{CRC} - 1\ \mathbf{do}$$
$$\quad \mathbf{for}\ \theta_{TC} = 0\ \text{to}\ N_{TC} - 1\ \mathbf{do}$$
$$\quad\quad \sigma_{CRC}(0) \leftarrow Prev\theta_{CRC}(\theta_{CRC}, 0)$$
$$\quad\quad \sigma_{CRC}(1) \leftarrow Prev\theta_{CRC}(\theta_{CRC}, 1)$$
$$\quad\quad \sigma_{CRC}(2) \leftarrow \theta_{CRC}$$
$$\quad\quad \sigma_{TC}(0) \leftarrow Prev\theta_{TC}(\theta_{TC}, 0)$$
$$\quad\quad \sigma_{TC}(1) \leftarrow Prev\theta_{TC}(\theta_{TC}, 1)$$
$$\quad\quad \sigma_{TC}(2) \leftarrow Prev\theta_{TC}(\theta_{TC}, 0)$$
$$\quad\quad t \leftarrow \arg\min_t \Gamma_{trans}((\sigma_{CRC}(t); \sigma_{TC}(t)), t)$$
$$\quad\quad \Gamma(k, (\theta_{CRC}; \theta_{TC})) \leftarrow \Gamma_{trans}((\sigma_{CRC}(t); \sigma_{TC}(t)), t)$$
$$\quad\quad P(k, (\theta_{CRC}; \theta_{TC})) \leftarrow P_{trans}((\sigma_{CRC}(t); \sigma_{TC}(t)), t)$$
$$\quad\quad S(k, (\theta_{CRC}; \theta_{TC})) \leftarrow S_{trans}((\sigma_{CRC}(t); \sigma_{TC}(t)))$$
$$\quad\quad R(k, (\theta_{CRC}; \theta_{TC})) \leftarrow t$$
$$\quad \mathbf{end\ for}$$
$$\mathbf{end\ for}$$

Partie 4 (lecture du chemin)

$$\theta_{CRC} \leftarrow 0$$
$$\theta_{TC} \leftarrow \theta_{TC}^f$$
$$n \leftarrow K - S(K, (0; \theta_{TC}^f))$$
$$\mathbf{for}\ k = K\ \text{to}\ 1\ \mathbf{do}$$
$$\quad t \leftarrow R(k, (\theta_{CRC}; \theta_{TC}))$$
$$\quad \mathbf{if}\ t \neq BS\ \mathbf{then}$$
$$\quad\quad \theta_{CRC} \leftarrow Prev\theta_{CRC}(\theta_{CRC}, t)$$
$$\quad\quad \theta_{TC} \leftarrow Prev\theta_{TC}(\theta_{TC}, t)$$
$$\quad\quad U_n \leftarrow t$$
$$\quad\quad n \leftarrow n - 1$$
$$\quad \mathbf{else}$$
$$\quad\quad \theta_{TC} \leftarrow Prev\theta_{TC}(\theta_{TC}, 0)$$
$$\quad \mathbf{end\ if}$$
$$\mathbf{end\ for}$$

## Revendications

1. Procédé de correction d'un message à corriger, le message à corriger ayant été généré par transformation d'un message initial et par insertion de bits de bourrage dans le message transformé, tous les deux suivant un protocole prédéterminé; le procédé comprenant
la mise à disposition d'une séquence d'observation contenant le message à corriger,
la construction d'une pluralité d'hypothèses de chemin à travers un treillis comprenant des noeuds et des branches, lesdites branches représentant les transitions possibles entre lesdits noeuds,
la sélection parmi lesdites hypothèses de chemin de l'hypothèse de chemin la plus probable par rapport à la séquence d'observation,

**caractérisé en ce que**
dans ledit treillis, lesdits noeuds représentent chacun un état d'une machine à états finis susceptible d'effectuer ladite transformation du message initial,
**en ce que** lesdites branches comprennent des branches représentant des transitions conditionnelles empruntables uniquement en présence d'un bit de bourrage,
et **en ce que** lors de la construction d'une hypothèse de chemin, des bits de bourrage sont détectés et les branches associées aux bits de bourrage détectés sont empruntées.

2. Procédé selon la revendication 1, dans lequel la construction de la pluralité d'hypothèses de chemin à travers le treillis et la sélection sont basées sur l'algorithme de Viterbi ou sur l'algorithme SOVA.

3. Procédé selon la revendication 1 ou 2, dans lequel ladite transformation du message initial comprend le calcul d'un bloc de contrôle de redondance cyclique qui est assemblé au message initial pour produire le message transformé, et dans lequel lesdits noeuds représentent chacun un état d'un calculateur susceptible d'avoir effectué le calcul du bloc de contrôle de redondance cyclique.

4. Procédé selon l'une quelconque des revendications 1 à 3, dans lequel, au fur et à mesure qu'une hypothèse de chemin est construite, un bit de bourrage est considéré détecté si les conditions selon lesquelles l'insertion d'un bit de bourrage est effectuée sont remplies.

5. Procédé selon la revendication 4, dans lequel une variable d'état est associée à chaque hypothèse de chemin, ladite variable d'état étant mise à jour, au fur et à mesure que l'hypothèse de chemin est construite, en fonction de la partie déjà construite de l'hypothèse de chemin, et dans lequel la variable d'état est surveillée pour déterminer si les conditions selon lesquelles l'insertion d'un bit de bourrage est effectuée sont remplies.

6. Procédé selon la revendication 5, dans lequel ladite variable d'état indique pour chaque hypothèse de chemin le nombre de bits consécutifs de la même valeur.

7. Procédé selon l'une quelconque des revendications 1 à 6,
dans lequel ladite transformation du message initial comprend le calcul d'un bloc de contrôle de redondance cyclique qui est assemblé au message initial pour produire le message transformé,
dans lequel le message à corriger est obtenu par décodage d'une séquence de symboles générée par encodage du message transformé après insertion de bits de bourrage, la sélection dudit chemin à travers le treillis faisant partie dudit décodage,
dans lequel les noeuds dudit treillis représentent les éléments d'un produit cartésien d'au moins l'ensemble des états d'un encodeur susceptible d'avoir effectué ledit encodage et de l'ensemble des états d'un calculateur susceptible d'avoir calculé le bloc de contrôle de redondance cyclique,
une transition d'un premier noeud, correspondant à un premier état d'encodeur et un premier état de calculateur, à un second noeud, correspondant à un second état d'encodeur et un second état de calculateur, étant possible,

  ○ en présence d'un bit de message transformé, si

    - par application de ce bit de message transformé à l'encodeur se trouvant dans le premier état d'encodeur, l'encodeur passe au second état d'encodeur, et
    - par application de ce bit de message transformé au calculateur se trouvant dans le premier état de calculateur, le calculateur passe au second état de calculateur,

  ○ ou, en présence d'un bit de bourrage, si

    - par application de ce bit de bourrage à l'encodeur se trouvant dans le premier état d'encodeur, l'encodeur passe au second état d'encodeur, et
    - le premier état de calculateur est égal au second état de calculateur.

8. Procédé selon l'une quelconque des revendications 1 à 7, dans lequel la séquence d'observation est obtenue à partir d'un signal AIS, par exemple reçu par un satellite, notamment par un satellite en orbite basse.

9. Procédé selon la revendication 8, dans lequel ladite séquence d'observation est obtenue à partir d'une pluralité de signaux AIS simultanés ou se chevauchant dans le temps.

**10.** Programme d'ordinateur contenant des instructions entraînant la mise en oeuvre du procédé selon l'une quelconque des revendications 1 à 9 lorsque le programme d'ordinateur est exécuté par un ordinateur.

**11.** Décodeur configuré pour la mise en oeuvre du procédé selon l'une quelconque des revendications 1 à 9.

**Patentansprüche**

**1.** Verfahren zum Korrigieren einer zu korrigierenden Nachricht, wobei die zu korrigierende Nachricht durch Transformieren einer ursprünglichen Nachricht und durch Einfügen von Stopfbits in die transformierte Nachricht generiert wurde, wobei alle zwei einem vorbestimmten Protokoll folgen; wobei das Verfahren umfasst
Bereitstellen einer Beobachtungssequenz, die die zu korrigierende Nachricht enthält,
Konstruieren einer Vielzahl von Weghypothesen durch ein Netz, welches Knoten und Zweige umfasst, wobei die Zweige die möglichen Übergänge zwischen den Knoten repräsentieren,
Auswählen, aus den Weghypothesen, der Weghypothese, die in Bezug auf die Beobachtungssequenz am wahrscheinlichsten ist,
**dadurch gekennzeichnet, dass**
in dem Netz die Knoten jeder einen Zustand eines endlichen Zustandsautomaten repräsentieren, der das Transformieren der ursprünglichen Nachricht vornehmen kann,
dadurch, dass die Zweige Zweige umfassen, die bedingte Übergänge repräsentieren, welche nur in Gegenwart eines Stopfbits genommen werden können,
und dadurch, dass beim Konstruieren einer Weghypothese Stopfbits erkannt werden und die Zweige, die mit den erkannten Stopfbits verknüpft sind, genommen werden.

**2.** Verfahren nach Anspruch 1, wobei das Konstruieren der Vielzahl von Weghypothesen durch das Netz und das Auswählen auf dem Viterbi-Algorithmus oder auf dem SOVA-Algorithmus basieren.

**3.** Verfahren nach Anspruch 1 oder 2, wobei das Transformieren der ursprünglichen Nachricht das Berechnen eines zyklischen Redundanzprüfblocks umfasst, der der ursprünglichen Nachricht angefügt wird, um die transformierte Nachricht zu erzeugen, und wobei die Knoten jeder einen Zustand eines Rechners repräsentieren, der die Berechnung des zyklischen Redundanzprüfblocks vorgenommen haben kann.

**4.** Verfahren nach einem der Ansprüche 1 bis 3, wobei in dem Zug, in dem eine Weghypothese konstruiert wird, ein Stopfbit als erkannt erachtet wird, wenn die Bedingungen, nach denen das Einfügen eines Stopfbits vorgenommen wird, erfüllt sind.

**5.** Verfahren nach Anspruch 4, wobei mit jeder Weghypothese eine Zustandsvariable verknüpft ist, wobei die Zustandsvariable in dem Zug, in dem die Weghypothese konstruiert wird, abhängig von dem bereits konstruierten Teil der Weghypothese aktualisiert wird, und wobei die Zustandsvariable überwacht wird, um zu bestimmen, ob die Bedingungen, nach denen das Einfügen eines Stopfbits vorgenommen wird, erfüllt sind.

**6.** Verfahren nach Anspruch 5, wobei die Zustandsvariable für jede Weghypothese die Anzahl von aufeinanderfolgenden Bits desselben Werts angibt.

**7.** Verfahren nach einem der Ansprüche 1 bis 6,
wobei das Transformieren der ursprünglichen Nachricht das Berechnen eines zyklischen Redundanzprüfblocks umfasst, der an die ursprüngliche Nachricht angefügt wird, um die transformierte Nachricht zu erzeugen,
wobei die zu korrigierende Nachricht durch Decodieren einer durch Codieren der transformierten Nachricht nach Einfügen von Stopfbits generierten Symbolsequenz erhalten wird, wobei das Auswählen des Wegs durch das Netz Teil des Decodierens bildet,
wobei die Knoten des Netzes die Elemente eines kartesischen Produkts aus mindestens der Gesamtheit der Zustände eines Codierers, der das Codieren vorgenommen haben kann, und der Gesamtheit der Zustände eines Rechners repräsentieren, der den zyklischen Redundanzprüfblock berechnet haben kann,
wobei ein Übergang von einem ersten Knoten, der einem ersten Codierer-Zustand und einem ersten Rechner-Zustand entspricht, zu einem zweiten Knoten, der einem zweiten Codierer-Zustand und einem zweiten Rechner-Zustand entspricht, möglich ist

- in Gegenwart eines transformierten Nachrichtenbits, wenn

-- durch Anwenden dieses transformierten Nachrichtenbits auf den Codierer, der sich im ersten Codierer-Zustand befindet, der Codierer in den zweiten Codierer-Zustand wechselt, und

-- durch Anwenden dieses transformierten Nachrichtenbits auf den Rechner, der sich im ersten Rechner-Zustand befindet, der Rechner in den zweiten Rechner-Zustand wechselt,

- oder in Gegenwart eines Stopfbits, wenn

-- durch Anwenden dieses Stopfbits auf den Codierer, der sich im ersten Codierer-Zustand befindet, der Codierer in den zweiten Codierer-Zustand wechselt, und

-- der erste Rechner-Zustand gleich dem zweiten Rechner-Zustand ist.

8. Verfahren nach einem der Ansprüche 1 bis 7, wobei die Beobachtungssequenz anhand eines AIS-Signals erhalten wird, das zum Beispiel von einem Satelliten, insbesondere von einem Satelliten in niedriger Umlaufbahn empfangen wird.

9. Verfahren nach Anspruch 8, wobei die Beobachtungssequenz anhand einer Vielzahl von gleichzeitigen oder sich zeitlich überschneidenden AIS-Signalen erhalten wird.

10. Computerprogramm, das Anweisungen enthält, welche die Umsetzung des Verfahrens nach einem der Ansprüche 1 bis 9 bewirken, wenn das Computerprogramm von einem Computer ausgeführt wird.

11. Decodierer, der für die Umsetzung des Verfahrens nach einem der Ansprüche 1 bis 9 konfiguriert ist.

**Claims**

1. A method for correcting a message to be corrected, the message to be corrected having been generated by transforming an initial message and by inserting stuffing bits into the transformed message, both following a predetermined protocol; the method comprising
   providing an observation sequence containing the message to be corrected,
   constructing a plurality of path hypotheses through a lattice comprising nodes and branches, said branches representing the possible transitions between said nodes,
   selecting, from said path hypotheses, the most probable path hypothesis relative to the observation sequence,
   **characterized in that**
   in said lattice, said nodes each represent a state of a finite state machine likely to perform said transformation of the initial message,
   **in that** said branches comprise branches representing conditional transitions that can be taken only in the presence of a stuffing bit.
   and **in that**, when constructing a path hypothesis, stuffing bits are detected and the branches associated with the detected stuffing bits are taken.

2. The method according to claim 1, wherein the construction of the plurality of path hypotheses through the lattice and the selection are based on the Viterbi algorithm or on the SOVA algorithm.

3. The method according to claim 1 or 2, wherein said transformation of the initial message comprises the calculation of a cyclic redundancy check block which is assembled to the initial message to produce the transformed message, and wherein said nodes each represent a state of a calculator likely to have calculated the cyclic redundancy check block.

4. The method according to any one of claims 1 to 3, wherein, as a path hypothesis is being constructed, a stuffing bit is considered detected if the conditions according to which the insertion of a stuffing bit is performed are met.

5. The method according to claim 4, wherein a state variable is associated with each path hypothesis, said state variable being updated, as the path hypothesis is being constructed, depending on the part already constructed of the path hypothesis, and wherein the state variable is monitored to determine if the conditions according to which the insertion of a stuffing bit is performed are met.

6. The method according to claim 5, wherein for each path hypothesis said state variable indicates the number of consecutive bits of the same value.

7. The method according to any one of claims 1 to 6,
   wherein said transformation of the initial message comprises the calculation of a cyclic redundancy check block which is assembled to the initial message to produce the transformed message,
   wherein the message to be corrected is obtained by decoding a sequence of symbols generated by encoding the transformed message after insertion of the stuffing bits, the selection of said path through the lattice being part of said decoding,
   wherein the nodes of said lattice represent the elements of a cartesian product of at least all of the states of an encoder likely to have performed said encoding and all of the states of a calculator likely to have calculated the cyclic redundancy check block,
   a transition from a first node, corresponding to a first encoder state and a first calculator state, to a second node, corresponding to a second encoder state and a second calculator state, being possible,

   ◦ in the presence of a transformed message bit, if

   - by applying this transformed message bit to the encoder being in the first encoder state, the encoder passes to the second encoder state, and
   - by applying this transformed message bit to the calculator being in the first calculator state, the calculator passes to the second calculator state,

   ◦ or, in the presence of a stuffing bit, if

   - by applying this stuffing bit to the encoder being in the first encoder state, the encoder passes to the second encoder state, and
   - the first calculator state is equal to the second calculator state.

8. The method according to any one of claims 1 to 7, wherein the observation sequence is obtained from an AIS signal, for example received by a satellite, in particular by a low earth orbit satellite.

9. The method according to claim 8, wherein said observation sequence is obtained from a plurality of simultaneous or time-overlapping AIS signals.

10. A computer program containing instructions causing the implementation of the method according to any one of claims 1 to 9 when the computer program is executed by a computer.

11. A decoder configured for the implementation of the method according to any one of claims 1 to 9.

**Fig. 1 (état de la technique)**

```
┌─────────────────────────┐
│  Message d'information   │ ~ 10
└─────────────────────────┘
            │
            ▼
┌─────────────────────────┐
│       Ajout CRC          │ ~ 12
└─────────────────────────┘
            │
            ▼
┌─────────────────────────┐
│   Insertion de bits de   │ ~ 14
│         bourrage         │
└─────────────────────────┘
            │
            ▼
┌─────────────────────────┐
│       Modulation         │ ~ 16
└─────────────────────────┘
            │
            ▼
┌─────────────────────────┐
│         Canal            │ ~ 18
└─────────────────────────┘
            │
            ▼
┌─────────────────────────┐
│      Démodulation        │ ~ 20
└─────────────────────────┘
            │
            ▼
┌─────────────────────────┐
│  Suppression des bits de │ ~ 22
│         bourrage         │
└─────────────────────────┘
            │
            ▼
┌─────────────────────────┐
│     Vérification CRC     │ ~ 24
└─────────────────────────┘
            │
            ▼
┌─────────────────────────┐
│    Sortie du message     │ ~ 26
└─────────────────────────┘
```

**Fig. 2 (état de la technique)**

Message d'information — 10

Ajout CRC — 12

Insertion de bits de bourrage — 14

Codage treillis — 15

Modulation — 16

Canal — 18

Démodulation — 20

Décodage — 21

Suppression des bits de bourrage — 22

Vérification CRC — 24

Sortie du message — 26

**Fig. 3 (état de la technique)**

5 uns consécutifs

| 0 | 1 | 0 | 1 | 1 | 1 | 1 | 1 | 1 | 1 | 0 | 0 | 1 | 1 | 0 | 0 | 0 | 0 |

Ajout de bit(s) de bourrage

| 0 | 1 | 0 | 1 | 1 | 1 | 1 | 1 | 0 | 1 | 1 | 0 | 0 | 1 | 1 | 0 | 0 | 0 | 0 |

**Fig. 4**

Séquence d'observation

Treillis CRC

Algorithme de Viterbi à transitions conditionnelles

30

**Fig. 5**

Treillis CRC

| 0 | 0 |
| 1 | 1 |
| 2 | 2 |
| 3 | 3 |

**Fig. 6**

**Treillis avec transitions conditionnelles**

**Fig. 7**

**Fig. 8**

**Fig. 9**

Séquence d'observation
(= séquence de symboles)

Treillis
CRC

Treillis
codage

Treillis « étendu »

Algorithme de Viterbi à
transitions conditionnelles

**32**

**Fig. 11 (exemple de comparaison)**

## Treillis CRC
### Etat initial : 1

0 → 0

0
1

1
0

1 → 1

## Treillis codage
### Etat initial : A

A → A

0    00
01

10
11

0
1

B → B

**Fig. 10 (exemple de comparaison)**

Treillis CRC

Treillis codage

Transitions des états étendus

Treillis étendu

## Fig. 12 (exemple de comparaison)

Distance cumulée

Minimum des
distances des chemins
(on élimine l'autre)

Erreur

Etat initial

Distance de la transition

**Fig. 13**

Treillis CRC

Treillis codage

**Transitions des états étendus**

Fig. 14

```
┌─────────────────────────┐
│  Message d'information à │
│        168 bits         │
└─────────────────────────┘
            │
            ▼
┌─────────────────────────┐
│  Ajout d'un bloc de CRC à│
│        16 bits          │
└─────────────────────────┘
            │
            ▼
┌─────────────────────────┐
│   Insertion de bits de  │
│         bourrage        │
└─────────────────────────┘
            │
            ▼
┌─────────────────────────┐
│      Codage NRZI        │
└─────────────────────────┘
            │
            ▼
┌─────────────────────────┐
│    Modulation GMSK      │
└─────────────────────────┘
            │
            ▼
┌─────────────────────────┐
│      Canal AWGN         │
└─────────────────────────┘
            │
            ▼
```

**Fig. 15**

**Fig. 16**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20080304597 A

**Littérature non-brevet citée dans la description**

- **B. MCDANIEL.** An algortithm for error correcting cyclic redundancy checks. *C/C++ Users Journal,* 2003, 6
- **S. BABAIE ; A. K. ZADEH ; S. H. ES-HAGI ; N. J. NVIMIPOUR.** Double bits error correction using CRC method. *International Conférence on Semantics, Knowledge and Grid,* 2009, 254-257
- **C. SHI-YI ; L. YU-BAI.** Error correcting cycle redundancy checks based on confidence declaration. *ITS Télécommunications Proceedings,* 2006, 511-514
- Design and implementation of WTB controller using SOPC technology. SIGNAL PROCESSING 2008. ICSP 2008. 9TH INTERNATIONAL CONFERENCE ON. IEEE, 26 Octobre 2008, 2804-2807
- Design note DN504, FEC implementation. *Texas Instruments Design Notes Repository,* 01 Janvier 2007, 1-11